# EUROPEAN PATENT APPLICATION

(11) **EP 1 677 416 A1**
(43) Date of publication of application: **05.07.2006**
(21) Application number: 04792681.1
(22) Date of filing: 20.10.2004
(51) Int. Cl.: H03F 3/24, H04B 1/04, H04B 7/26, H04J 13/00

(54) **NON-LINEAR CIRCUIT, RADIO COMMUNICATION DEVICE, AND NON-LINEAR AMPLIFICATION METHOD**

(30) Priority: 21.10.2003 JP 2003361257
(71) Applicant: MATSUSHITA ELECTRIC INDUSTRIAL CO., LTD., Kadoma-shi, Osaka 571-8501 (JP)
(72) Inventor: MIURA, Ritsu, // (JP)
(74) Representative: Grünecker, Kinkeldey, Stockmair & Schwanhäusser Anwaltssozietät
(86) International application number: PCT/JP2004/015515
(87) International publication number: WO 2005/039042

(57) **Abstract**

Anonlinear circuit, nonlinear amplificationmethod, and radio communication apparatus equipped with this nonlinear circuit are disclosed whereby, when a transmit/receive signal in which a plurality of channels whose inter-slot boundary arrival times do not coincide are multiplexed is amplified by means of a nonlinear element, timings at which the set value of an applied voltage or applied current supplied to the nonlinear circuit is caused to make a transition are selected, thereby reducing the number of times these set values are caused to make a transition, and furthermore, an applied voltage or applied current actually supplied to the nonlinear element is made to reach the selected set value sooner, and the occurrence of distortion due to transmit/receive signal amplification is suppressed. In this apparatus, the set value of an applied voltage supplied to an amplifier (102) is normally calculated based on information input from an operating condition input terminal (104), but when notification is given by a timing selection section (112) of a set value that differs from the calculated applied voltage set value, a different applied voltage is supplied to the amplifier (102) in accordance with that notification.

## Description

### Technical Field

The present invention relates to a radio communication apparatus and a nonlinear circuit provided in a radio communication apparatus, and also a nonlinear amplification method implemented by this nonlinear circuit and so forth.

### Background Art

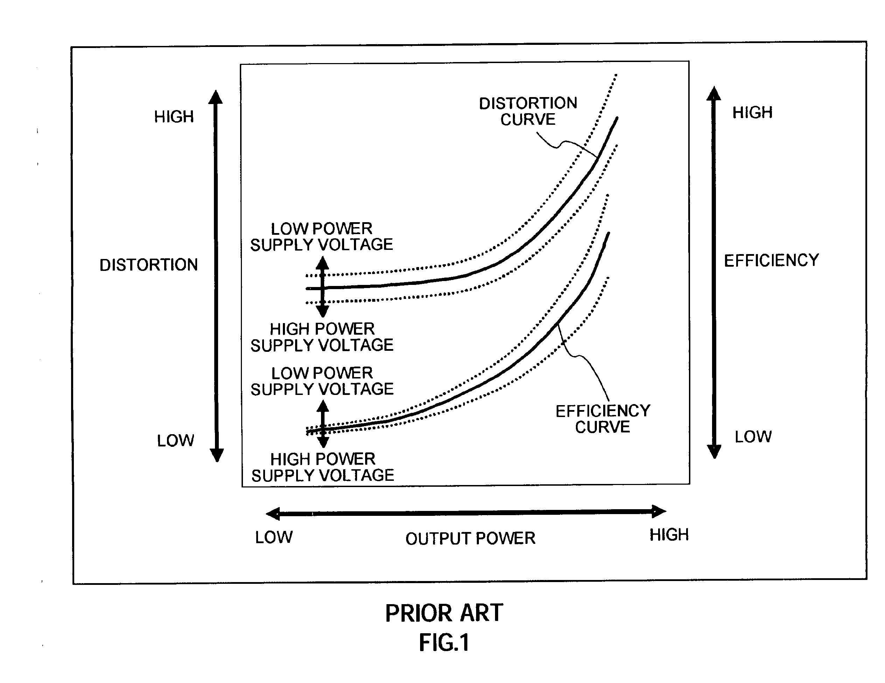

Heretofore, in amplifiers, modulators, or the like provided in radio communication apparatuses, nonlinear elements have been used for which a variation in the applied voltage or applied current and the variation arising therefrom are not directly proportional. Generally, if the power supply voltage is constant, a nonlinear circuit equipped with nonlinear elements exhibits higher distortion and higher efficiency as output power increases, and conversely, exhibits lower distortion and lower efficiency as output power decreases, as shown in FIG.1. Also, as can be seen from FIG.1, if output power is constant, a nonlinear circuit exhibits higher distortion and higher efficiency as the power supply voltage decreases, and conversely, exhibits lower distortion and lower efficiency as the power supply voltage increases.

Extension of communication time and standby time by suppressing power consumption, as well as improvement of communication quality, are required of radio communication apparatuses, and more particularly mobile communication terminal apparatuses such as mobile phones, equipped with nonlinear circuits. This is the same as requiring radio communication apparatuses to amplify transmit/receive signals with high efficiency and low distortion. However, since high efficiency and low distortion are conflicting characteristics for a nonlinear circuit, as is clear from FIG.1, it is difficult to implement a radio communication apparatus that satisfies both these characteristics at the same time. Furthermore, the amount of distortion that occurs when a transmit/receive signal is amplified varies according to the transmit/receive signal modulation method, signal level (power level), and so forth, and therefore it is necessary for a radio communication apparatus to adaptively adjust the applied voltage or applied current supplied to the amplifier, or the amplifier gain and so forth, according to variations in these nonlinear circuit and similar operating conditions.

In order to perform highly efficient, low-distortion amplification of transmit/receive signals in a conventional radio communication apparatus, a technology is generally used that permits distortion generated by a nonlinear circuit up to a stipulated value upper limit of the radio communication system specification, and also lowers the applied power supply voltage. For example, there are known a technology that takes a set standard for the power supply voltage supplied to a nonlinear circuit as the output power from this nonlinear circuit or the input power to this nonlinear circuit, and a technology that monitors the signal level of a transmit/receive signal input to a nonlinear circuit, and adaptively adjusts the applied voltage according to the peak power to average power ratio of that transmit/receive signal, and its modulation method or modulation speed (see Patent Document 1, Patent Document 2, and Patent Document 3).

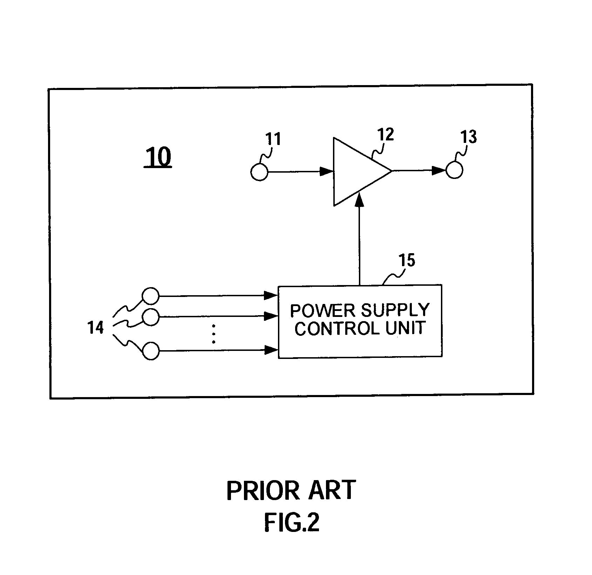

FIG. 2 is a block diagram showing the configuration of a conventional general nonlinear circuit 10. This nonlinear circuit 10 has a transmit/receive signal input terminal 11, an amplifier 12, a transmit/receive signal output terminal 13, a power supply set value input terminal 14, and a power supply control unit 15.

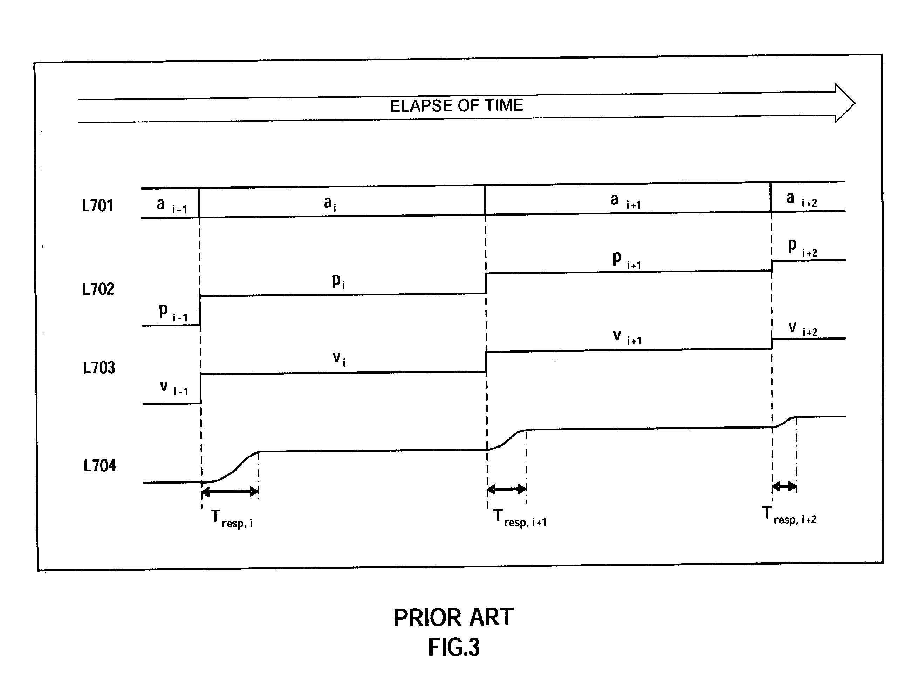

FIG.3 is a timing chart showing the voltage, etc., in each component part of nonlinear circuit 10 when the slots shown in line L701 (ai-1, ai, ai+1, ai+2) are input from transmit/receive signal input terminal 11 of nonlinear circuit 10 to amplifier 12. In FIG.3, line L702 shows amplifier 12 per-slot output power target values (Pi-1, Pi, Pi+1, Pi+2), line L703 shows power supply control unit 15 per-slot applied voltage set values (Vi-1, Vi, Vi+1, Vi+2), and line L704 shows the applied voltages actually supplied from power supply control unit 15 to amplifier 12 . Power supply control unit 15 should ideally supply the applied voltages shown in line L703 to amplifier 12, but when the configuration of power supply control unit 15 includes a DC-DC converter or the like, the actual applied voltage cannot keep pace with transitions of the set value, and therefore time lag periods (Tresp,i, Tresp,i+1, Tresp,i+2) occur as shown in line L704.

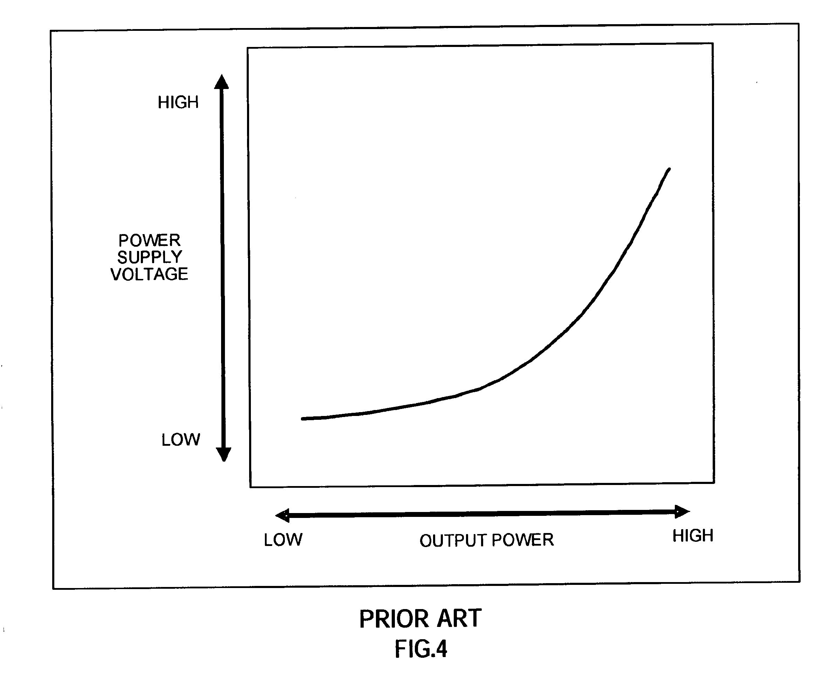

FIG.4 shows an example of the relationship between output power and applied voltage for amplifier 12. Generally, in amplifier 12, since the output signal itself is an operating condition for performing highly efficient operation while satisfying the distortion permitted by the radio communication system specification, there is a trend for the power supply voltage that must be applied to increase as the output power increases.

Next, the operation of nonlinear circuit 10 will be described, referring to FIG.2, FIG.3, and FIG.4 as appropriate. A transmit/receive signal input to transmit/receive signal input terminal 11 is amplified by amplifier 12, and then output to transmit/receive signal output terminal 13. On the other hand, information on the power to be output by amplifier 12 (including the amplifier 12 output power target value) is input from power supply set value input terminal 14 to power supply control unit 15. Power supply control unit 15 adjusts the power supply voltage applied to amplifier 12 based on the input amplifier 12 output power target value after taking the characteristic shown in FIG.4 into consideration. Since the signal level of the transmit/receive signal input to amplifier 12 varies on a slot-by-slot basis as shown in line L701, the amplifier 12 output power target value also varies serially in accordance with transitions of the signal level of the input transmit/receive signal. Power supply control unit 15 adjusts the power supply voltage applied to amplifier 12 in accordance with these amplifier 12 output power transitions, but due to the characteristics of the DC-DC converter provided in power supply control unit 15, the applied voltage variation time lag periods (Tresp, i, Tresp, i+1, Tresp, i+2) shown in line L704 occur.

In a time lag period that arises because the actual applied voltage cannot keep pace with transitions of the applied voltage set value as shown in line L704 (which may hereinafter be referred to as a "transient period") , the applied voltage actually supplied from power supply control unit 15 to amplifier 12 naturally deviates from the applied voltage set value shown in line L703, and therefore transmit/receive signal distortion may increase as regards the amplifier 12 output power. However, since transmit/receive signal distortion caused by amplification by amplifier 12 is averaged time-wise in the transmit/receive signal slot units shown in line L701, if transient periods are short the increase in transmit/receive signal distortion is slight, and the quality of communication using nonlinear circuit 10 is not degraded significantly. Differences between actual power supply control unit 15 applied voltages shown in line L704 and power supply control unit 15 applied voltage set values shown in line L703 in transient periods tend to become apparent when the actual applied voltage is lower than the applied voltage set value.
Patent Document 1 : Unexamined Japanese Patent Publication No.SHO 63-155904
Patent Document 2: Unexamined Japanese Patent Publication No.2001-244828
Patent Document 3: Unexamined Japanese Patent Publication No. 2001-320288

### Disclosure of Invention

### Problems to be Solved by the Invention

However, with conventional nonlinear circuit 10, each time new information related to an amplifier 12 output voltage target value is input from power supply set value input terminal 14 to power supply control unit 15, the power supply control unit 15 applied voltage set value shown in line L703 makes a transition. If applied voltage set values used by power supply control unit 15 make frequent transitions - that is, if the valid period of individual applied voltage set values is short - many transient periods will occur, and therefore an increase in transmit/receive signal distortion will become apparent as regards amplifier 12 output power, and the communication quality of a radio communication apparatus equipped with nonlinear circuit 10 will degrade.

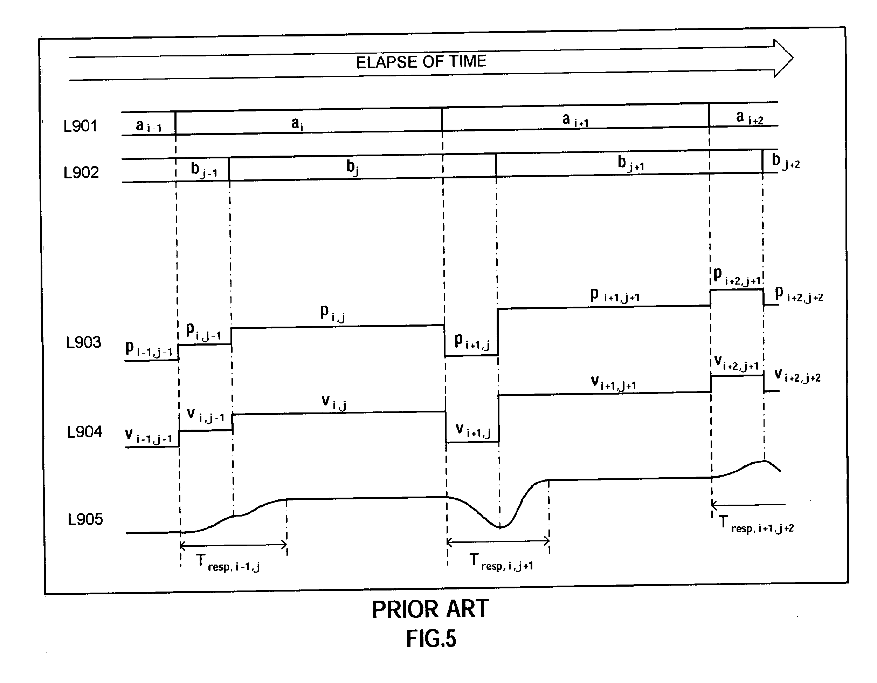

FIG.5 is a timing chart showing the voltage, etc. , in each component part of nonlinear circuit 10 when the channel A slots shown in line L901 (ai-1, ai, ai+1, ai+2) and channel B slots shown in line L902 (bj-1, bj, bj+1, bj+2) are code division multiplexed and then input from transmit/receive signal input terminal 11 to amplifier 12. As can be seen from FIG.5, the boundaries between slots in channels A and B do not coincide in the timing. Line L903 shows amplifier 12 output power target values (Pi-1,j-1, Pi,j-1, Pi,j, Pi+1,j, Pi+1,j+1, Pi+2,j+1, Pi+2, j+2) , line L904 shows power supply control unit 15 to amplifier 12 applied voltage set values (Vi-1,j-1, Vi, j-1, Vi,j, Vi+1, j, Vi+1, j+1, Vi+2, j+1, Vi+2,j+2), and line L905 shows the applied voltages actually supplied from power supply control unit 15 to amplifier 12.

In FIG.5, since the channel A boundaries between slots and the channel B boundaries between slots do not coincide in the timing, the applied voltages actually supplied from power supply control unit 15 to amplifier 12 in line L905 have a greater amount of variation and longer transient periods than in the case of a single channel - that is, line L704. As a result, transmit/receive signal distortion increases as regards amplifier 12 output power, and a problem arises of degradation of the communication quality of a radio communication apparatus equipped with nonlinear circuit 10. In FIG. 5, a case is illustrated in which two channels are code division multiplexed, but if the number of multiplexed channels is further increased, transmit/receive signal distortion will increase significantly as regards amplifier 12 output power, and the problem of degradation of the communication quality of a radio communication apparatus equipped with nonlinear circuit 10 will become more readily apparent.

It is an object of the present invention to provide a nonlinear circuit and nonlinear amplification method whereby, when a transmit/receive signal in which a plurality of channels whose inter-slot boundary arrival times do not coincide are multiplexed is amplified by means of a nonlinear element, timings at which the set value of an applied voltage or applied current supplied to the nonlinear circuit is caused to make a transition are selected, thereby reducing the number of times these set values are caused to make a transition, and furthermore, an applied voltage or applied current actually supplied to the nonlinear element is made to reach the selected set value sooner, and the occurrence of distortion due to transmit/receive signal amplification is suppressed, as well as a radio communication apparatus equipped with this nonlinear circuit.

### Means for Solving the Problem

A nonlinear circuit according to the present invention employs a configuration equipped with a nonlinear element that amplifies an input signal in which a plurality of channels whose inter-slot boundary arrival times do not coincide are multiplexed; a control section that controls a voltage or current supplied to the nonlinear element; and a selection section that selects timings at which the control section causes a set value of the aforementioned voltage or current to make a transition.

### Advantageous Effect of the Invention

According to the present invention, the above-described timings are selected as appropriate, as a result of which the number of occurrences of transient periods are reduced, and individual transient periods are also shortened, enabling distortion occurring in a transmit/receive signal due to amplification by a nonlinear circuit to be significantly reduced.

### Brief Description of Drawings

FIG.1 is a graph showing distortion occurring in a conventional general nonlinear circuit and efficiency thereof;
FIG.2 is a block diagram showing the configuration of a conventional general nonlinear circuit;
FIG.3 is a timing chart explaining the operation of a conventional general nonlinear circuit;
FIG.4 is a graph showing the relationship between power supply voltage and output power in a conventional general nonlinear amplifier;
FIG.5 is a timing chart explaining the operation of a conventional general nonlinear circuit;
FIG.6 is a block diagram showing the configuration of a nonlinear circuit according to Embodiment 1 of the present invention;
FIG.7 is a timing chart explaining the operation of a nonlinear circuit according to Embodiment 1 of the present invention;
FIG.8 is a block diagram showing the configuration of a nonlinear circuit according to Embodiment 2 of the present invention; and
FIG.9 is a timing chart explaining the operation of a nonlinear circuit according to Embodiment 2 of the present invention.

### Best Mode for Carrying Out the Invention

Embodiments of the present invention will now be described in detail with reference to the accompanying drawings as appropriate.

### (Embodiment 1)

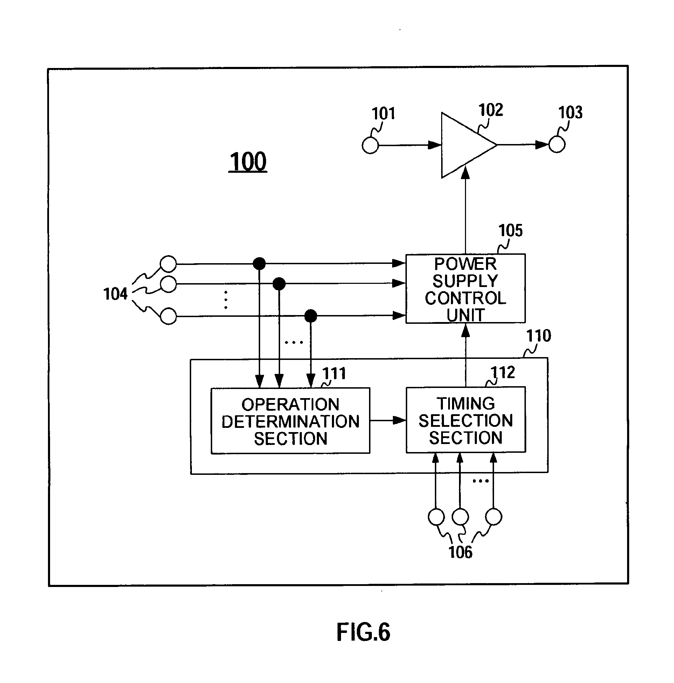

FIG.6 is a block diagram showing the configuration of a nonlinear circuit 100 according to Embodiment 1 of the present invention. Nonlinear circuit 100 has a transmit/receive signal input terminal 101, an amplifier 102, a transmit/receive signal output terminal 103, operating condition input terminals 104, a power supply control unit 105, timing signal input terminals 106, and an operating section 110. Nonlinear circuit 100 is installed in a radio communication apparatus such as a mobile phone or similar mobile station, a base station, or the like, and amplifies transmit signals or received signals of that radio communication apparatus.

Operating section 110 has an operation determination section 111 and a timing selection section 112, and controls the operation of power supply control unit 105.

A transmit/receive signal code division multiplexed with channel A and channel B whose inter-slot boundaries do not coincide in the timing is input to transmit/receive signal input terminal 101 from a signal processing section (not shown). The transmit/receive signal input to transmit/receive signal input terminal 101 is input to amplifier 102.

Amplifier 102 is a nonlinear amplifier comprising a general-purpose low-noise amplifier or the like that amplifies a code division multiplexed transmit/receive signal input from transmit/receive signal input terminal 101 based on preset gain and then outputs the amplified signal to transmit/receive signal output terminal 103. The gain of amplifier 102 can be adjusted as appropriate, but in this embodiment it is assumed that the gain is fixed.

A signal processing section (not shown) is connected to transmit/receive signal output terminal 103. An amplified transmit/receive signal input to the signal processing section from transmit/receive signal output terminal 103 undergoes predetermined signal processing, and is then transmitted as a radio signal or decoded as a data signal.

A plurality of operating condition input terminals 104 are provided, and information indicating the channel A signal level and information indicating the channel B signal level are input to terminals thereamong. These items of information indicating the individual channel signal levels are then input to power supply control unit 105 and operation determination section 111.

Power supply control unit 105 is supplied with continuous power from a power supply section (not shown) , and based on information indicating the channel A signal level and information indicating the channel B signal level input from operating condition input terminal 104, calculates the transmit/receive signal level in a case where the transmit/receive signals of these channels are code division multiplexed. Using this calculated signal level as the set value of the power supply voltage to be applied to amplifier 102, power supply control unit 105 supplies an applied voltage using that set value to amplifier 102. If power supply control unit 105 is notified by timing selection section 112 that a set value different from the calculated signal level is to be used for the applied voltage supplied to amplifier 102, power supply control unit 105 supplies amplifier 102 with an applied voltage using the set value notified from timing selection section 112 in accordance with that notification. In power supply control unit 105, also, transient periods occur in the same way as with conventional amplifier 12 in the event of applied voltage set value transitions.

A plurality of timing signal input terminals 106 are provided, to one of which a timing signal A indicating that an inter-slot boundary has arrived for a channel A transmit/receive signal is input, and to another of which a timing signal B indicating that an inter-slot boundary has arrived for a channel B transmit/receive signal is input. Timing signals A and B input to terminals among timing signal input terminals 106 are input to timing selection section 112. Timing signal A and timing signal B, a transmit/receive signal in which channel A and channel B are code division multiplexed input from transmit/receive signal input terminal 101 to amplifier 102, and information indicating the signal level of a channel A transmit/receive signal and information indicating the signal level of a channel B transmit/receive signal input from operating condition input terminals 104 to power supply control unit 105 and operation determination section 111, are linked respectively. Therefore, by monitoring timing signal A and timing signal B, operating section 110 can ascertain the condition of transmit/receive signals input to amplifier 102 and power supply control unit 105 and so forth.

Operation determination section 111 performs time series accumulation and monitoring of information indicating channel specific signal levels input from operating condition input terminals 104, and determines the channel specific signal level cycles. Based on the determined channel specific signal level cycles, operation determination section 111 predicts a signal level after either a channel A or channel B signal level input from an operating condition input terminal 104 makes a transition. Then, operation determination section 111 calculates the signal level of a transmit/receive signal code division multiplexed at that predicted post-transition signal level, and inputs this calculated post-transition transmit/receive signal level to timing selection section 112 as occasion requires.

By performing time series accumulation and monitoring of timing signal A and timing signal B input from timing signal input terminals 106, timing selection section 112 predicts the transmit/receive signal level transition timing in a case where the respective channel transmit/receive signals are code division multiplexed. Based on this predicted transition timing and the signal level of a post-transition transmit/receive signal input from operation determination section 111, timing selection section 112 calculates the signal level of a code division multiplexed transmit/receive signal immediately after timing signal A is input and the signal level of a code division multiplexed transmit/receive signal immediately after timing signal B input following timingsignalAis input. Then, taking into consideration the input interval between timing signal A and timing signal B, and the signal level after timing signal A is input and the signal level after timing signal B is input, timing selection section 112 selects the more suitable of timing signal A or timing signal B for adjusting the transmit/receive signal level. Furthermore, when the non-selected timing signal is input from a timing signal input terminal 106, timing selection section 112 notifies power supply control unit 105 so that the signal level set value of the transmit/receive signal after the selected timing signal input thereafter is input is used.

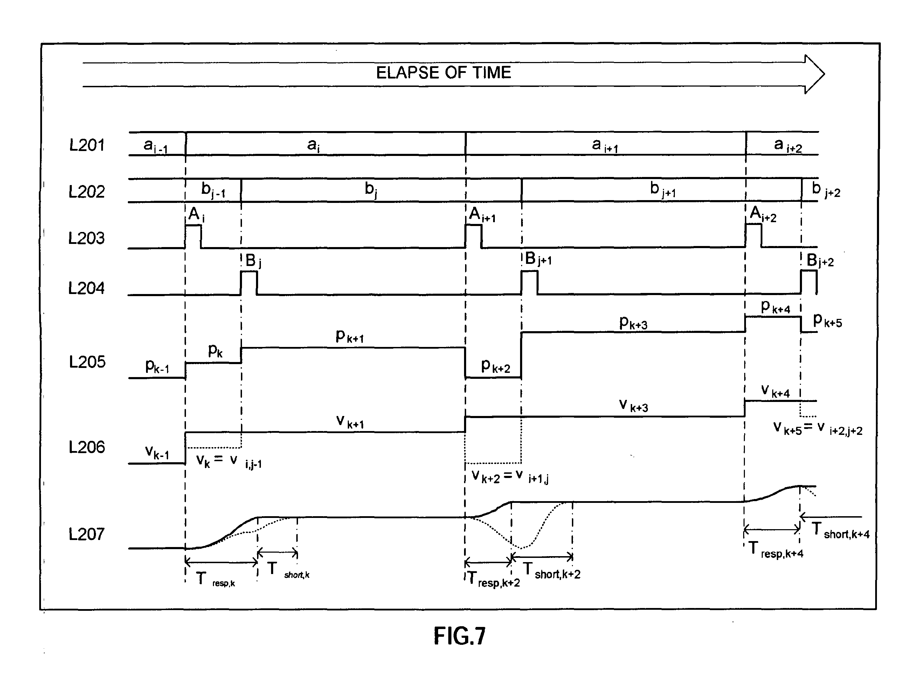

Next, the operation of nonlinear circuit 100 will be described in detail with reference to FIG.7. FIG.7 is a timing chart showing voltage set values and actual applied voltages in the component parts of nonlinear circuit 100 when the channel A slots (ai-1, ai, ai+1, ai+2) shown in line L201 and the channel B slots (bj-1, bj, bj+1, bj+2) shown in line L202 are code division multiplexed and then input from transmit/receive signal input terminal 101 to amplifier 102.

The channel A slots (ai-1, ai, ai+1, ai+2) shown in line L201 are the same as the line L901 slots (ai-1, ai, ai+1, ai+2) shown in FIG.5, and the channel B slots (bj-1, bj, bj+1, bj+2) shown in line L202 are the same as the channel B slots (bj-1, bj, bj+1, bj+2) shown in line L902. Therefore, FIG.7 shows showing the applied voltage set values, etc., in each component part of nonlinear circuit 100 in the case where the transmit/receive signals shown in FIG.5 are amplified by nonlinear circuit 100.

In FIG. 7, the boundaries between slots in channels A and B do not coincide in the timing. Also, in FIG.7, line L203 shows timing signal A giving notification of the arrival of an inter-slot boundary of channel A input from timing signal input terminal 106 to timing selection section 112, and line L204 shows timing signal B giving notification of the arrival of an inter-slot boundary of channel B input likewise.

Line L205 shows amplifier 102 output power target values. In line L205, since amplifier 102 output power target values differ due to the superimposition of the channel A slots (ai-1, ai, ai+1, ai+2) shown in line L201 and the channel B slots (bj-1, bj, bj+1, bj+2) shown in line L202, the notation "Pk-1, Pk, Pk+1, Pk+2, Pk+3, Pk+4, Pk+5" is used for the amplifier 102 output voltage target values.

Line L206 shows set values of applied voltages supplied to amplifier 102 by power supply control unit 105. In line L206, also, since power supply control unit 105 applied voltage set values differ due to the superimposition of the channel A slots (ai-1, ai, ai+1, ai+2) shown in line L201 and the channel B slots (bj-1, bj, bj+1, bj+2) shown in line L202, the notation "Vk-1, Vk, Vk+1, Vk+2, Vk+3, Vk+4, Vk+5" is used for the amplifier 102 output voltage target values. Applied voltage set values Vk, Vk+2, and Vk+5 in line L206 are indicated by dotted lines. Applied voltage set values Vk, Vk+2, and Vk+5 are the same as applied voltage set values Vi-1, j-1, Vi+1, j , and Vi+2,j+2 respectively in line L904 shown in FIG.5.

Line L207 shows applied voltages actually supplied to amplifier 102 from power supply control unit 105. In line L207 transient periods Tresp, k, Tresp, k+2, and Tresp, k+4 are shown, and the applied voltages in line L905 shown in FIG.5 are indicated by dotted lines. In line L207, also, taking the transient periods shown in line L905 in FIG.5 as a basis, periods shorter than those periods are indicated by the notation "Tshort,k, Tshort,k+2, Tshort,k+4."

The operation of each component part of nonlinear circuit 100 will now be described, referring to FIG.5 as appropriate, taking the example of the slot ai+1 period in line L201 shown in FIG.7.

At the time when the channel A transmit/receive signal slot transits from slot ai to slot ai+1, information indicating the slot ai+1 signal level is input from operating condition input terminal 104 to power supply control unit 105 and operation determination section 111, and at the same time, timing signal Ai+1 is input from timing signal input terminal 106 to timing selection section 112.

Inpower supplycontrol unit 105, when information indicating the slot ai+1 signal level is input from operating condition input terminal 104, set value Vk+2 of the applied voltage to be supplied to amplifier 102 is calculated.

On the other hand, in operation determination section 111, when information indicating the slot ai+1 signal level is input from operating condition input terminal 104, the signal level of slot bj+1 that is due to arrive next is predicted with reference to the signal levels of each channel A slot and the signal levels of each channel B slot accumulated up to that time, and based on this predicted value, the signal level of a transmit/receive signal when slot ai+1 and slot bj+1 are code division multiplexed is calculated. Operation determination section 111 then inputs this calculated signal level of a transmit/receive signal when slot ai+1 and slot bj+1 are code division multiplexed directly to timing selection section 112. It is also possible for the slotbj+1 signal level predicted value, the calculated value of the signal level of a transmit/receive signal when slot ai+1 and slot bj+1 are code divisionmultiplexed, and the like, to be generated by a component part other than operation determination section 111, or set beforehand, and to be input from operating condition input terminal 104 to operation determination section 111.

Thus, timing signal Ai+1, and the signal level of a transmit/receive signal when slot ai+1 and slot bj+1 are code division multiplexed, are input respectively to timing selection section 112. Timing selection section 112 accumulates timing signals A and B input from timing signal input terminals 106 and their input times, and the signal level of a transmit/receive signal input from operation determination section 111, as a time series, and by referencing these accumulated timing signal A and B times, predicts the input times of timing signal Bj+1 due to be input next. Timing selection section 112 then compares the signal level of a transmit/receive signal when slot ai+1 and slot bj+1 are code division multiplexed immediately after timing signal Ai+1 is input, and the signal level of a transmit/receive signal when slot ai+1 and slot bj+1 are code division multiplexed immediately after timing signal Bj+1 is input, and also compares the period from when timing signal Ai+1 is input until timing signal Bj+1 is input, and the period from when timing signal Bj+1 is input until timing signal Ai+2 is input, and selects the period in which the signal level is higher (the highest value) and the period from timing signal Bj+1 to timing signal Ai+2 is longer as the appropriate period. Then timing selection section 112 notifies power supply control unit 105 that transmit/receive signal level set value Vk+3 is to be used in the selected period. In this embodiment, the period with the higher signal level is the longer period, but if, for example, a period that has a high signal level and is shorter and a period that has a low signal level and is longer are compared, the period that has the higher signal level and is shorter will be selected. If the period that has the higher signal level and is shorter is selected as the appropriate period, this is because, in transmit/receive signal amplification by amplifier 102, although the amplification efficiency falls, the occurrence of distortion is reduced.

On receiving notification to use applied voltage set value Vk+3, power supply control unit 105 rejects applied voltage set value Vk+2 in accordance with that notification, and uses applied voltage set value Vk+3 immediately after the arrival of the boundary between slot ai and slot ai+1 in channel A. Therefore, in transient period Tresp, k+2, the applied voltage actually supplied to amplifier 102 from power supply control unit 105 continues to rise without falling, and consequently distortion due to transmit/receive signal amplification by amplifier 102 is suppressed. Moreover, the applied voltage actually supplied to amplifier 102 from power supply control unit 105 can reach the corresponding set value Vk+3 in a short time. That is to say, using nonlinear circuit 100 enables the applied voltage to be made to reach set value Vk+3 by power supply control unit 105 earlier by period Tshort, k+2 in line L207 shown in FIG. 7 than in the case where conventional nonlinear circuit 10 is used.

Thus, according to nonlinear circuit 100 of this embodiment, even when a transmit/receive signal in which channel A and channel B whose inter-slot boundary arrival times do not coincide are multiplexed is amplified by means of amplifier 102, which is a nonlinear element, by continually reducing the number of times the set value of an applied voltage supplied to amplifier 102 is cause to make a transition, and selecting a more appropriate applied voltage set value, the generation of transmit/receive signal distortion dependent upon amplification by amplifier 102 can be suppressed, and the actual applied voltage can be made to reach the selected applied voltage set value in a shorter time. Therefore, if a radio communication apparatus is equipped with nonlinear circuit 100 according to this embodiment, better communication quality can be maintained even in an adverse communication environment.

Also, according to nonlinear circuit 100 of this embodiment, timing selection section 112 selects the timing at which power supply control unit 105 causes a voltage set value to make a transition in synchronization with the arrival time of a boundary between slots in a plurality of channels, thereby enabling the operation of the selection section to be simplified.

Furthermore, according to nonlinear circuit 100 of this embodiment, timing selection section 112 selects the timing at which power supply control unit 105 causes a voltage set value to make a transition in synchronization with the arrival time of a boundary between slots in a plurality of channels, and also predicts the highest value of the voltage set value in the period between the time at which timing is selected and the time at which timing is next selected, and notifies power supply control unit 105 of the predicted highest value and causes the voltage set value to make a transition to the highest value, as a result of which the applied voltage set value used by power supply control unit 105 is always maintained at the highest value, thereby enabling the occurrence of distortion to be effectively suppressed in input signal (transmit/receive signal) amplification by amplifier 102, which is a nonlinear element.

Moreover, according to nonlinear circuit 100 of this embodiment, in a transient period until the voltage actually supplied to amplifier 102 reaches the set value, timing selection section 112 does not select the timing for causing that set value to make a transition, thereby making it possible to avoid a situation in which the next transient period begins before the current transient period ends, and to prevent the successive occurrence of transient periods over a long interval.

Also, a radio communication apparatus according to this embodiment, being equipped with nonlinear circuit 100, enables communication quality to be improved in radio communications.

Nonlinear circuit 100 according to this embodiment may be modified or adapted as described below.

For nonlinear circuit 100 according to this embodiment, a case has been described in which the voltage of a transmit/receive signal is amplified by amplifier 102, but the present invention is not limited to this case, and the current of a transmit/receive signal may be amplified using a nonlinear circuit element such as a transistor in amplifier 102, for example. Also, both the voltage and current of a transmit/receive signal may be amplified by amplifier 102.

Furthermore, for nonlinear circuit 100 according to this embodiment, a case has been described in which the signal level of a transmit/receive signal input to amplifier 102 makes a transition depending on the superimposition condition of slots of each channel, but the present invention is not limited to this case, and may also be applied to cases in which, for example, the signal level of a transmit/receive signal makes a transition depending on an increase or decrease in the number of channels multiplexed in a transmit/receive signal, or depending on variation of the peak power to average power ratio of a transmit/receive signal, a change of the modulation method, or variation of the modulation speed. Nonlinear circuit 100 can also provide the above-described actions and effects in such cases.

In this embodiment, a case has been described in which timing selection section 112 gives notification to power supply control unit 105 for the use of applied voltage set value Vk+3 immediately after the arrival of the boundary between slot ai and slot ai+1 in channel A, but the present invention is not limited to this case, and timing selection section 112 may, for example, cause an applied voltage set value transition by power supply control unit 105 only when either timing signal A or timing signal B is input, and not cause an applied voltage set value transition when the other timing signal is input. Specifically, in FIG.7, timing selection section 112 may give notification to power supply control unit 105 for the use of applied voltage set value Vk when timing signal Ai is input, and give notification to power supply control unit 105 for the continued use of applied voltage set value Vk when timing signal Bj is input. If this is done, timing selection section 112 need only distinguish between timing signal A and timing signal B, enabling the configuration and operation of operating section 110 to be simplified, and also enabling the power supply voltage actually applied to amplifier 102 to be made to reach the relevant set value, and stabilized, in a short time. However, in FIG.7, if timing selection section 112 gives notification to power supply control unit 105 for the use of applied voltage set value Vk+2 when timing signal Ai+1 is input, and gives notification to power supply control unit 105 for the continued use of applied voltage set value Vk+2 when timing signal Bj+1 is input, the applied voltage set value will be kept low in the period from timing signal Ai+1 until timing signal Ai+2, resulting in a problem of increased distortion due to transmit/receive signal amplification by amplifier 102. Therefore, to counter this problem, it is desirable for measures to be taken such as providing a lower limit for applied voltage set values.

### (Embodiment 2)

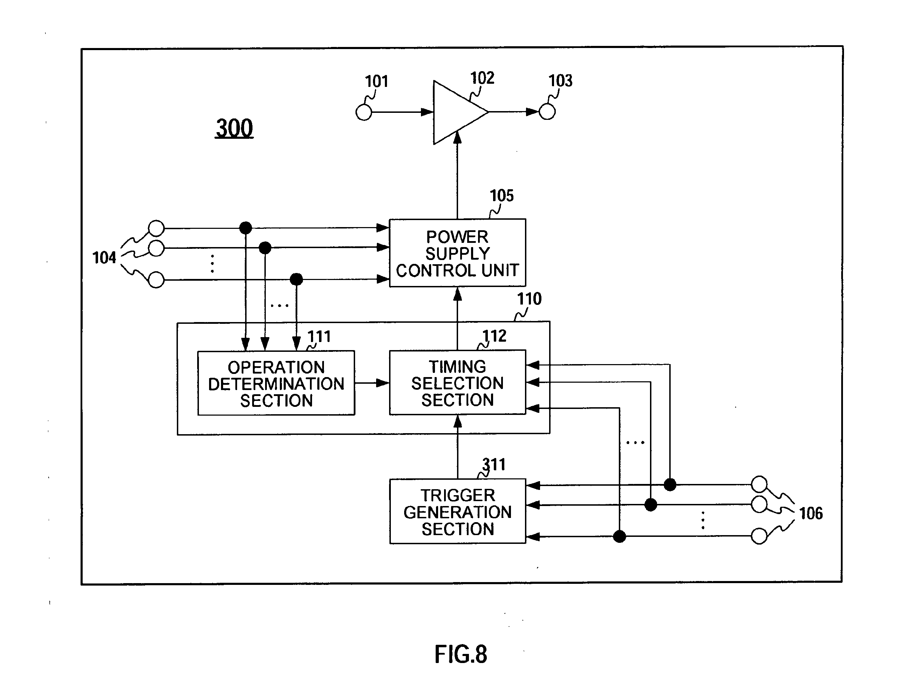

FIG.8 is a block diagram showing the configuration of a nonlinear circuit 300 according to Embodiment 2 of the present invention. In nonlinear circuit 300, a trigger generation section 311 is newly added to nonlinear circuit 100 according to Embodiment 1. Therefore, since almost all the configuration elements of nonlinear circuit 300 perform similar functions to corresponding configuration elements of nonlinear circuit 100, descriptions of such configuration elements that perform similar functions are omitted to avoid duplication.

When timing signal A or timing signal B is input from a timing signal input terminal 106, trigger generation section 311 inputs a trigger to timing selection section 112 at preset timing.

Timing selection section 112 performs the same kind of operation as described in Embodiment 1, conditional upon the input of a trigger from trigger generation section 311, and notifies power supply control unit 105 of the applied voltage set value and the timing for causing a transition of that set value.

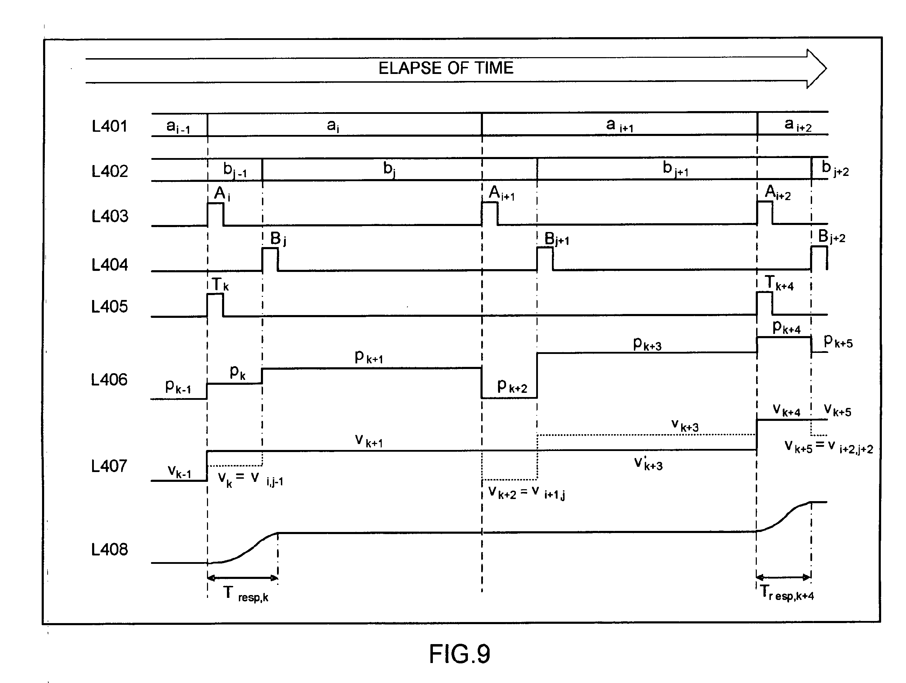

Next, the operation of nonlinear circuit 300 according to this embodiment, and more particularly the operation of trigger generation section 311 and timing selection section 112, will be described in detail with reference to FIG.9.

FIG.9 is a timing chart showing voltage set values, actual applied voltages, etc., in each component part of nonlinear circuit 300 when the channel A slots shown in line L401 (ai-1, ai, ai+1, ai+2) and channel B slots shown in line L402 (bj-1, bj, bj+1, bj+2) are code division multiplexed and then input from transmit/receive signal input terminal 101 of nonlinear circuit 300 to amplifier 102.

FIG.9 corresponds to FIG.7, with line L401 identical to line L201, line L402 identical to line L202, line L403 identical to line L203, line L404 identical to line L204, and line L406 identical to line L205. FIG.9 and FIG.7 differ in that there is no line in FIG.7 corresponding to line L405 in FIG.9, applied voltage set value V'k+3 in line L407 in FIG.9 is applied voltage set value Vk+3 in line L206 in FIG.7, and transient period Tresp,k+2 in line L206 in FIG.7 does not occur in line L408 in FIG.9. Line L405 in FIG.9 shows triggers input from trigger generation section 311 to timing selection section 112.

As can be seen by comparing line L403 with line L405, trigger generation section 311 is set so as to input a trigger to timing selection section 112 once for every two inputs of timing signal A. When a trigger is input from trigger generation section 311, timing selection section 112 operates as follows, in the same way as in Embodiment 1. That is to say, by performing time series accumulation and monitoring of timing signal A and timing signal B input from timing signal input terminals 106, timing selection section 112 predicts the timing of a transition of the signal level of a transmit/receive signal in a case where transmit/receive signals of each channel are code division multiplexed. Based on this predicted transition timing and the signal level of a post-transition transmit/receive signal input from operation determination section 111, timing selection section 112 calculates the signal level of a code division multiplexed transmit/receive signal immediately after timing signal A is input and the signal level of a code division multiplexed transmit/receive signal immediately after timing signal B input following timing signal A is input. Then, taking into consideration the input interval between timing signal A and timing signal B, and the signal level after timing signal A is input and the signal level after timing signal B is input, timing selection section 112 selects the more suitable of timing signal A or timing signal B for adjusting the transmit/receive signal level. Furthermore, when the non-selected timing signal is input from a timing signal input terminal 106, timing selection section 112 notifies power supply control unit 105 so that the signal level set value of the transmit/receive signal after the selected timing signal input thereafter is input is used.

By having a trigger Tk input from trigger generation section 311 to timing selection section 112, the line L407 applied voltage set value becomes Vk+1 immediately after the arrival of the boundary between slot ai-1 and slot ai in channel A. Then, since a trigger is not generated by trigger generation section 311 when the boundary between slot ai and slot ai+1 arrives in channel A, the line L407 applied voltage set value is kept at V'k+3=Vk+1. Next, since a trigger Tk+4 is generated by trigger generation section 311 when the boundary between slot ai+1 and slot ai+2 arrives in channel A, the line L407 applied voltage set value is caused to make a transition to Vk+4. Thus, in this embodiment, transient period Tresp,k+2 in line L206 in FIG.7 does not occur in line L408, and the number of applied voltage set value transitions by power supply control unit 105 can be seen to have been reduced.

Thus, according to nonlinear circuit 300 of this embodiment, generation of a trigger by trigger generation section 311 is a precondition for an applied voltage set value transition by power supply control unit 105, and therefore the number of occurrences of transient periods for an applied voltage actually supplied to amplifier 102 can be reduced by adjusting the trigger generation timing of trigger generation section 311. As a result, the occurrence of transmit/receive signal distortion due to amplification by amplifier 102 can be significantly suppressed.

Also, according to nonlinear circuit 300 of this embodiment, the provision of trigger generation section 311 allows greater design and setting flexibility for timing selection section 112 and power supply control unit 105, and enables a significantly wider range of distortion and efficiency settings to be made with regard to transmit/receive signal amplification by nonlinear circuit 300.

If trigger generation section 311 is configured by combining logic circuits such as OR and AND circuits, various kinds of trigger can be generated, enabling more precise conditions to be applied to the operation of trigger generation section 311.

The present application is based on Japanese Patent Application No.2003-361257 filed on October 21, 2003, the entire content of which is expressly incorporated by reference herein.

### Industrial Applicability

A nonlinear circuit, radio communication apparatus, and nonlinear amplification method according to the present invention provide for timings at which the set value of an applied voltage or applied current supplied to a nonlinear element is caused to make a transition to be selected by a control section, enabling the number of times the control section causes the set value to make a transition to be reduced, and therefore have an effect of enabling distortion occurring in a transmit/receive signal due to amplification by a nonlinear circuit to be reduced, and are useful for mobile stations, base stations, and so forth, in a radio communication system.

## Claims

1. A nonlinear circuit comprising:
a nonlinear element that amplifies an input signal in which a plurality of channels whose inter-slot boundary arrival times do not coincide are multiplexed;
a control section that controls a voltage or current supplied to said nonlinear element; and
a selection section that selects timing at which said control section causes a set value of said voltage or said current to make a transition.

2. The nonlinear circuit according to claim 1, wherein said selection section selects timing at which said control section causes said set value of said voltage or said current to make a transition in synchronization with an arrival time of an inter-slot boundary in a plurality of said channels.

3. The nonlinear circuit according to claim 1, wherein said selection section selects timing at which said control section causes said set value of said voltage or said current to make a transition in synchronization with an arrival time of an inter-slot boundary in a plurality of said channels, and also predicts a highest value of said set value between a time at which said timing is selected and a time at which said timing is next selected, notifies said control section of predicted said highest value, and causes said set value to make a transition to said highest value.

4. The nonlinear circuit according to claim 1, wherein, in a transient period until said voltage or said current actually supplied to said nonlinear element reaches said set value, said selection section does not select said timing for causing said set value to make a transition.

5. The nonlinear circuit according to claim 1, further comprising a generation section that generates a trigger that causes said selection section to select said timing.

6. A radio communication apparatus equipped with the nonlinear circuit according to claim 1.

7. A nonlinear amplification method comprising:
an amplifying step of amplifying an input signal in which a plurality of channels whose inter-slot boundary arrival times do not coincide are multiplexed;
a controlling step of controlling a voltage or current used in amplification in said amplifying step; and
a selecting step of selecting timing at which a set value of said voltage or said current used in said controlling step is caused to make a transition.

8. The nonlinear amplification method according to claim 7, further comprising a generating step of generating a trigger that causes selection of said timing in said selecting step.
